(19) Europäisches Patentamt

European Patent Office

Office européen des brevets

(11) **EP 1 737 123 A1**

(12) **EUROPEAN PATENT APPLICATION**

(43) Date of publication:
**27.12.2006 Bulletin 2006/52**

(51) Int Cl.:
*H03B 27/00* (2006.01)    *H03H 9/68* (2006.01)

(21) Application number: **06009787.0**

(22) Date of filing: **11.05.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **15.06.2005 KR 20050051646**

(71) Applicant: **Samsung Electronics Co., Ltd.**
**Suwon-si, Gyeonggi-Do (KR)**

(72) Inventors:
• **Jun, Si-Bum**
  **Yeongtong-gu**
  **Suwon-si**
  **Gyeonggi-do (KR)**

• **Park, Sang-Keun**
  **Yeongtong-gu**
  **Suwon-si**
  **Gyeonggi-do (KR)**
• **Lee, Woo-Yong**
  **Yeongtong-gu**
  **Suwon-si**
  **Gyeonggi-do (KR)**

(74) Representative: **Grünecker, Kinkeldey,**
**Stockmair & Schwanhäusser**
**Anwaltssozietät**
**Maximilianstrasse 58**
**80538 München (DE)**

(54) **Quadrature phase oscillator using complex coefficient filter**

(57) A quadrature phase oscillator in a Radio Frequency (RF) transceiver Integrated Circuit (IC) is provided. The quadrature phase oscillator includes a voltage controlled oscillator and a filter. The voltage controlled oscillator provides an oscillating frequency for modulation of a transmission/reception signal according to an applied voltage. The filter receives the oscillating frequency from the voltage controlled oscillator as an input, passes one of a negative frequency component of the input oscillating frequency and a positive frequency component of the input oscillating frequency, attenuates the other frequency component, generates an I (In phase) signal that is in phase with the input oscillating frequency and a Q (Quadrature phase) signal having a phase difference of 90° with the input oscillating frequency for the passed frequency component, and outputs the I signal and the Q signal.

FIG.1

EP 1 737 123 A1

**Description**

The present invention generally relates to a Radio Frequency (RF) transceiver Integrated Circuit (IC), and in particular, to a quadrature phase oscillator used in an RF transceiver IC.

Generally, a Radio Frequency (RF) transceiver Integrated Circuit (IC) transceives data using I/Q modulation. I/Q modulation involves modulating transmission/reception signals into a quadrature signal in which an In phase (I) signal and a Quadrature phase (Q) signal are quadrature to each other. In I/Q modulation, to express a transmission/reception signal in a complex coordinate system, the real component of the transmission/reception signal is expressed as the I signal and the imaginary component of the transmission/reception signal is expressed as the Q signal.

An RF transceiver IC typically generates an oscillating frequency for modulation of a transmission/reception signal using a Voltage Controlled Oscillator (VCO) that oscillates at a predetermined frequency according to an applied voltage and separates the generated oscillating frequency into an I component and a Q component having a phase difference of 90°, thereby generating I/Q signals. The generated I/Q signals are mixed with the transmission/reception signal, thereby modulating the transmission/reception signal.

However, according to the prior art, the I/Q signals are usually generated by a Resistor-Capacitor (R-C) polyphase filter or Master-Slave Flip-Flops (FF) on an RF chip of an RF transceiver IC.

The R-C polyphase filter separates an oscillating frequency into an I component and a Q component having a phase difference of 90°, using a phase characteristic of the R-C filter. When the R-C polyphase filter is used, a resistor and a capacitor on the RF chip of the RF transceiver IC occupy a considerable chip area and an area of a section showing a quadrature phase characteristic having an accurate phase difference of 90° is very small.

The Master-Slave FF applies a frequency that is $2^N$ times higher than a desired oscillating frequency to N cascaded Master-Slave FF and extracts an I component and a Q component corresponding to a desired output frequency from each of the Master-Slave FF. When the Master-Slave FF are used, the bandwidth of a section showing a quadrature phase characteristic having an accurate phase difference of 90° in an output signal is larger than when the R-C polyphase filter is used. However, FF performing a division function should be implemented and a larger amount of power is consumed for driving the FF. Moreover, the Master-Slave FF generates a frequency that is $2^N$ times higher than a desired oscillating frequency, causing an increase in current consumption.

It is, therefore, the object of the present invention to provide a quadrature phase oscillator using a complex coefficient filter having a large bandwidth showing a quadrature phase characteristic.

This object is solved by the subject matter of the independent claims.

Preferred embodiments are defined in the dependent claims.

It is an aspect of the present invention to provide a quadrature phase oscillator using a complex coefficient filter having no need to provide an oscillating frequency that is higher than a desired oscillating frequency.

It is another aspect of the present invention to provide a quadrature phase oscillator using a complex coefficient filter requiring low power consumption.

To achieve the above, there is provided a quadrature phase oscillator in a Radio Frequency (RF) transceiver Integrated Circuit (IC). The quadrature phase oscillator includes a voltage controlled oscillator and a filter. The voltage controlled oscillator provides an oscillating frequency for modulation of a transmission/reception signal according to an applied voltage. The filter receives the oscillating frequency from the voltage controlled oscillator as an input, passes one of a negative frequency component of the input oscillating frequency and a positive frequency component of the input oscillating frequency, attenuates the other frequency component, generates an I (In phase) signal that is in phase with the input oscillating frequency and a Q (Quadrature phase) signal having a phase difference of 90° with the input oscillating frequency for the passed frequency component, and outputs the I signal and the Q signal.

The present invention will become more apparent from the following detailed description when taken in conjunction with the accompanying drawings in which:

FIG. 1 is a block diagram of a quadrature phase oscillator using a complex coefficient filter according to the present invention;

FIG. 2 illustrates the characteristic of a complex coefficient Surface Acoustic Wave (SAW) filter according to the present invention;

FIG. 3 illustrates the complex coefficient SAW filter according to the present invention; and

FIG. 4 illustrates input/output signals of the complex coefficient SAW filter according to the present invention.

A preferred embodiment of the present invention will now be described in detail with reference to the annexed drawings. In the following description, a detailed description of known functions and configurations incorporated herein has been omitted for conciseness.

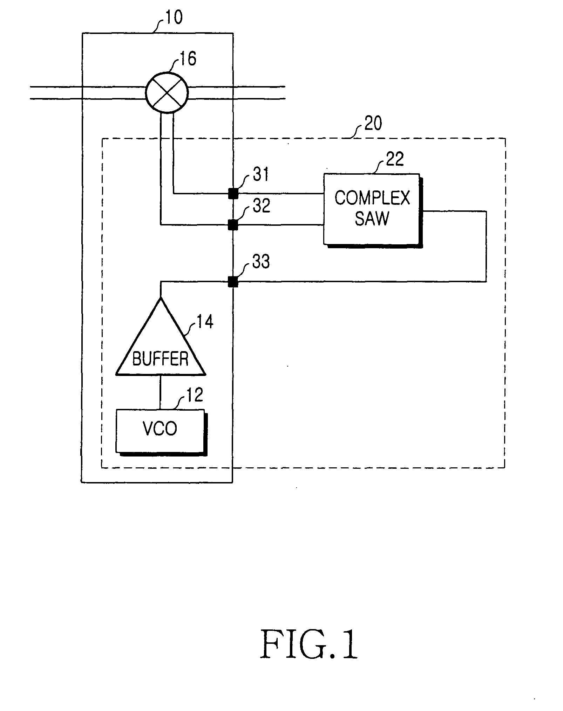

FIG. 1 is a block diagram of a quadrature phase oscillator 20 using a complex coefficient filter according to the present invention.

Referring to FIG. 1, the quadrature phase oscillator 20 according to the present invention generates I/Q signals using a complex coefficient Surface Acoustic Wave (SAW) filter 22 instead of a conventional R-C polyphase filter or Master-Slave Flip-Flops (FF).

According to the present invention, the quadrature phase oscillator 20 includes a Voltage Controlled Oscillator (VCO) 12, a buffer 14, and the complex coefficient SAW filter 22. The VCO 12 provides an oscillating frequency for modulating a transmission/reception signal according to an applied voltage, while the buffer 14 provides the oscillating frequency from the VCO 12 to the complex coefficient SAW filter 22.

The complex coefficient SAW filter 22 is a passive device outside a Radio Frequency (RF) transceiver Integrated Circuit (IC) chip 10 and is connected between the buffer 14 and a mixer 16 within the RF transceiver IC chip 10 through IC pins 31 through 33. The complex coefficient SAW filter 22 receives the oscillating frequency from the VCO 12 as an input and generates an I signal that is in phase with an input signal and a Q signal having a phase difference of 90° with the input signal to the mixer 16. The mixer 16 then mixes the I/Q signals with a transmission/reception signal, thereby modulating the transmission/reception signal.

Hereinafter, the complex coefficient SAW filter 22 of the quadrature phase oscillator 20 according to the present invention will be described in more detail.

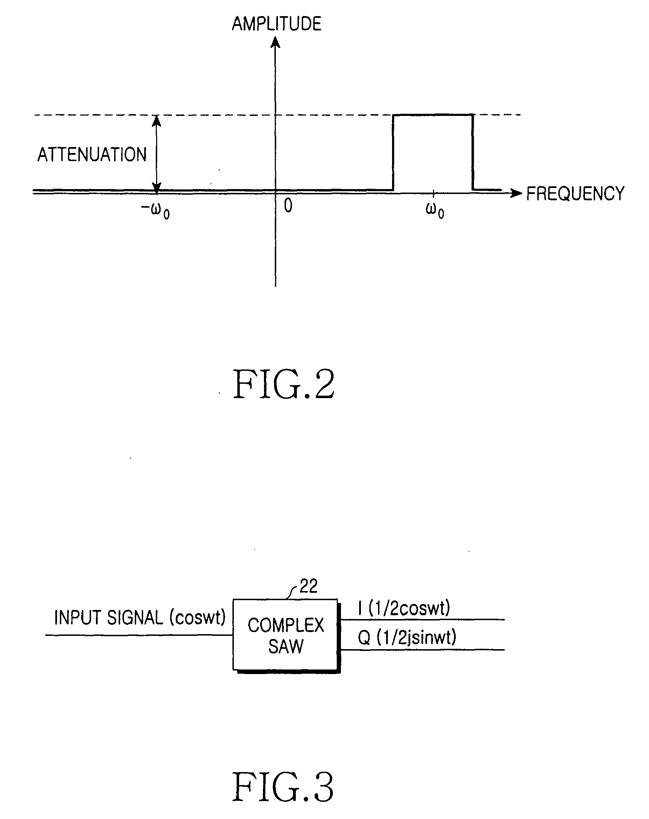

FIG. 2 illustrates the characteristic of the complex coefficient SAW filter 22 according to the present invention. Referring to FIG. 2, if a Continuous Wave (CW) signal of the oscillating frequency from the VCO 12 is applied, the complex coefficient SAW filter 22 passes one of a negative frequency component and a positive frequency component of the CW signal.

As shown in FIG. 2, the complex coefficient SAW filter 22 passes a positive frequency component of the CW signal. For example, upon input of the CW signal, the complex coefficient SAW filter 22 passes a positive frequency component, i.e., a signal in a frequency band of $+\omega_0$ and attenuates a negative frequency component, i.e., a signal in a frequency band of $-\omega_0$.

According to the present invention, the passed positive frequency component can be expressed as a complex signal. The complex signal has a real component and an imaginary component that can be expressed to have a phase difference of 90°. The complex coefficient SAW filter 22 separates the passed positive frequency component into a real component and an imaginary component having a phase difference of 90° and outputs the real component and the imaginary component as an I signal and a Q signal.

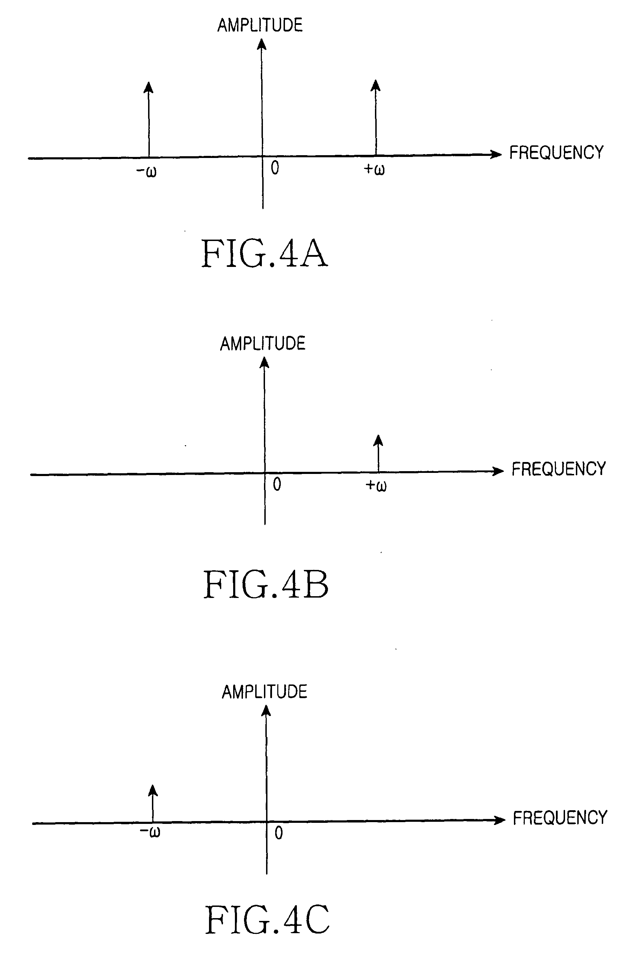

FIG. 3 illustrates the complex coefficient SAW filter 22 according to the present invention, and FIG. 4 illustrates input/output signals of the complex coefficient SAW filter 22 according to the present invention.

An operation of the complex coefficient SAW filter 22 according to an input signal of cos(ωt) that is a sine wave will now be described with reference to FIGs. 3 and 4.

Cos(ωt) input to the complex coefficient SAW filter 22 in FIG. 3 can be expressed in Equation (1) as follows:

$$\cos(\omega t) = \frac{e^{j\omega t} + e^{-j\omega t}}{2} \qquad \ldots \ldots \ldots \ldots (1),$$

where $\dfrac{e^{j\omega t}}{2}$ is a positive frequency component and $\dfrac{e^{-j\omega t}}{2}$ is a negative frequency component.

An input signal as expressed in Equation (1) can be shown in (a) of FIG. 4. In (a) of FIG. 4, a positive frequency component and a negative frequency component are shown.

According to the present invention, the complex coefficient SAW filter 22 separates an input signal into a positive frequency component and a negative frequency component.

The positive frequency component $\dfrac{e^{j\omega t}}{2}$ can be shown in (b) of FIG. 4 and the negative frequency component $\dfrac{e^{-j\omega t}}{2}$ can be shown in (c) of FIG. 4.

When the positive frequency component is selected, the negative frequency component is removed by the complex coefficient SAW filter 22 and only the positive frequency component $\dfrac{e^{j\omega t}}{2}$ is passed by the complex coefficient SAW filter 22 as shown in (b) of FIG. 4.

The positive frequency component $\dfrac{e^{j\omega t}}{2}$ can be expressed in Equation (2) as follows:

$$\frac{1}{2}\left\{\cos(\omega t)+j\sin(\omega t)\right\} \qquad \ldots\ldots\ldots\ldots (2),$$

where $\dfrac{1}{2}\cos(\omega t)$ indicates a real component that is in phase with the input signal (cos(ω$t$)) of the complex coefficient SAW filter 22 and $\dfrac{1}{2}j\sin(\omega t)$ indicates an imaginary component having a phase difference of 90° with the input

signal ( cos(ω$t$)) of the complex coefficient SAW filter 22.

The complex coefficient SAW filter 22 separates the positive frequency component $\dfrac{e^{j\omega t}}{2}$ into the real com-

ponent $\dfrac{1}{2}\cos(\omega t)$ and the imaginary component $\dfrac{1}{2}j\sin(\omega t)$ and outputs them through different output terminals.

In other words, upon input of the CW signal, the complex coefficient SW filter 22 separates the CW signal into a real component and an imaginary component and outputs the real component and the imaginary component as an I signal that is in phase with the CW signal and a Q signal having a phase difference of 90° with the CW signal.

The complex coefficient SAW filter 22 according to the present invention has a limited amount of attenuation as shown in FIG. 2 and the amount of attenuation of the complex coefficient SAW filter 22 determines the accuracy of a quadrature phase characteristic of I/Q signals output by the complex coefficient SAW filter 22.

For example, if the negative frequency component of an input signal is not sufficiently attenuated by the complex coefficient SAW filter 22, the remaining negative frequency component has an influence upon the positive frequency component of the input signal, resulting in an inaccurate quadrature characteristic of I/Q signals.

When the negative frequency component of an input signal is not sufficiently attenuated by the complex coefficient SW filter 22, the output of the complex coefficient SW filter 22 can be expressed in Equation (3) as follows:

$$\frac{1}{2}\left\{\cos(\omega t)+j\sin(\omega t)\right\}+\frac{\delta}{2}\left\{\cos(\omega t)-j\sin(\omega t)\right\} \qquad \ldots\ldots\ldots\ldots (3),$$

where $\dfrac{\delta}{2}\left\{\cos(\omega t)-j\sin(\omega t)\right\}$ indicates the negative frequency component of an input signal and δ indicates the amplitude of the remaining negative frequency component.

To sufficiently attenuate a negative frequency component, the amount of attenuation of the complex coefficient SAW filter 22 should be sufficiently small so that δ is negligible.

At this time, when δ is expressed in dB, it is preferable that the amount of attenuation of the complex coefficient SAW filter 22 be larger than -20log δ dB.

As described above, according to the present invention, it is not necessary to mount an R-C polyphase filter or Master-Slave FF on an RF transceiver IC chip, contributing to simple and easy implementation of a quadrature phase oscillator. Moreover, by using a complex coefficient SAW filter that is a passive device, current consumption can be reduced when compared to a conventional quadrature phase oscillator using Master-Slave FF that are active devices.

In addition, in the present invention, a Local Oscillator (LO) distributor or a 90° phase shifter and a high VCO frequency are not required, thereby reducing current consumption when compared to a conventional quadrature phase oscillator. Furthermore, in the present invention, since I/Q signals having an accurate quadrature phase characteristic can be acquired by increasing the amount of attenuation of a complex coefficient SAW filter, degradation in a Signal-to-Noise Ratio (SNR) due to an inaccurate quadrature phase characteristic of I/Q signals can be prevented.

While the present invention has been shown and described with reference to a preferred embodiment thereof, it will be understood by those skilled in the art that various changes in form and details may be made therein without departing from the scope of the invention. For example, although a positive frequency component is passed in the quadrature phase oscillator 20 according to an embodiment of the present invention, I/Q signals can be acquired even when a negative frequency component is passed.

## Claims

1. A quadrature phase oscillator in a radio frequency transceiver integrated circuit, the quadrature phase oscillator comprising:

   a voltage controlled oscillator for providing an oscillating frequency for modulation of a transmission/reception signal according to an applied voltage; and
   a filter for receiving the oscillating frequency from the voltage controlled oscillator as an input, passing one of a negative frequency component of the input oscillating frequency and a positive frequency component of the input oscillating frequency, attenuating the other frequency component, generating an I, In phase, signal that is in phase with the input oscillating frequency and a Q, Quadrature phase, signal having a phase difference of 90° with the input oscillating frequency for the passed frequency component, and outputting the I signal and the Q signal.

2. The quadrature phase oscillator of claim 1, wherein the filter is a complex coefficient surface acoustic wave filter.

3. The quadrature phase oscillator of claim 1, wherein the filter separates the passed frequency component into a real component that is a complex signal and an imaginary component and outputs the real component and the imaginary component as the I signal and the Q signal.

4. The quadrature phase oscillator of claim 1, wherein the filter passes only the positive frequency component of the input oscillating frequency.

5. The quadrature phase oscillator of claim 1, wherein the filter passes only the negative frequency component of the input oscillating frequency.

6. The quadrature phase oscillator of one of claims 1 to 5, wherein the amount of attenuation for attenuating one of the negative frequency component of the input oscillating frequency and the positive frequency component of the input oscillating frequency is determined to be sufficiently small such that an amplitude of the remaining portion of a frequency component to be attenuated is negligible.

FIG.1

AMPLITUDE

ATTENUATION

$-\omega_0$    0    $\omega_0$     FREQUENCY

# FIG.2

INPUT SIGNAL (coswt) | COMPLEX SAW $\widehat{\phantom{x}}$22 | I (1/2coswt)
Q (1/2jsinwt)

# FIG.3

AMPLITUDE

FREQUENCY

−ω          0          +ω

## FIG.4A

AMPLITUDE

FREQUENCY

0          +ω

## FIG.4B

AMPLITUDE

FREQUENCY

−ω          0

## FIG.4C

**European Patent Office**

## EUROPEAN SEARCH REPORT

Application Number

EP 06 00 9787

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CROLS J ET AL: "TA 8.1: A FULLY INTEGRATED 900MHZ CMOS DOUBLE QUADRATURE DOWNCONVERTER" IEEE INTERNATIONAL SOLID STATE CIRCUITS CONFERENCE, IEEE SERVICE CENTER, NEW YORK, NY, US, vol. 38, 15 February 1995 (1995-02-15), pages 136-137,352, XP000557582 ISSN: 0193-6530 * figure 1 * * the whole document * | 1,3-6 | INV. H03B27/00 H03H9/68 |
| X | WO 02/51003 A2 (KONINKL PHILIPS ELECTRONICS NV [NL]) 27 June 2002 (2002-06-27) | 1,3-6 | |
| Y | * page 4, line 21 - page 6, line 13; figures 2a-2c * | 2 | |
| Y | GB 2 029 148 A (GEN ELECTRIC CO LTD) 12 March 1980 (1980-03-12) * abstract; figure * | 2 | |
| A | NOTTEN M ET AL: "A low-IF bipolar double-quadrature mixer exhibiting 53 dB of image rejection" BIPOLAR/BICMOS CIRCUITS AND TECHNOLOGY, 2004. PROCEEDINGS OF THE 2004 MEETING MONTREAL, CANADA SEPT. 12-14, 2004, PISCATAWAY, NJ, USA,IEEE, 12 September 2004 (2004-09-12), pages 128-131, XP010746139 ISBN: 0-7803-8618-3 * page 128, right-hand column; figure 1 * | 1-6 | TECHNICAL FIELDS SEARCHED (IPC) H03B H03H |

The present search report has been drawn up for all claims

| Place of search | Date of completion of the search | Examiner |
|---|---|---|
| Munich | 23 October 2006 | Robinson, Victoria |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 06 00 9787

This annex lists the patent family members relating to the patent documents cited in the above-mentioned European search report.
The members are as contained in the European Patent Office EDP file on
The European Patent Office is in no way liable for these particulars which are merely given for the purpose of information.

23-10-2006

| Patent document cited in search report | | Publication date | Patent family member(s) | | Publication date |
|---|---|---|---|---|---|
| WO 0251003 | A2 | 27-06-2002 | AT | 291791 T | 15-04-2005 |
| | | | CN | 1443394 A | 17-09-2003 |
| | | | DE | 60109645 D1 | 28-04-2005 |
| | | | DE | 60109645 T2 | 09-02-2006 |
| | | | JP | 2004516739 T | 03-06-2004 |
| | | | US | 2002080718 A1 | 27-06-2002 |
| GB 2029148 | A | 12-03-1980 | NONE | | |

EPO FORM P0459